# EUROPÄISCHE PATENTANMELDUNG

(11) **EP 1 764 845 A1**
(43) Veröffentlichungstag der Anmeldung: **21.03.2007**
(21) Anmeldenummer: 06014427.6
(22) Anmeldetag: 12.07.2006
(51) Int. Cl.: H01L 41/09

(54) **Piezo-Biegewandler**

(30) Priorität: 15.09.2005 DE 202005014561 U
(71) Anmelder: Festo AG & Co., 73734 Esslingen (DE)
(72) Erfinder: Schmid, Andreas Joseph, Dr. Ing., 96450 Coburg (DE); Weinmann, Michael, Dr.-Ing., 73655 Plüderhausen (DE)
(74) Vertreter: Vetter, Hans

(57) **Zusammenfassung**

Es wird ein Piezo-Biegewandler mit einem streifen- oder plattenförmigen Biegewandlerelement (4) vorgeschlagen, das einen mit einem piezoelektrischen Körper (17) belegten Tragkörper (15) aufweist, der als überwiegend mit unidirektionalen Carbon-Fasern verstärkter Kunstharzkörper ausgebildet ist. Der Tragkörper (15) weist durch Verwendung von Hochmodul-Carbon-Fasern ein E-Modul größer als 180 GPa und einen thermischen Ausdehnungskoeffizienten kleiner als 2 x 10⁻⁶/K auf.

## Beschreibung

Die Erfindung betrifft einen Piezo-Biegewandler mit einem streifen- oder plattenförmigen Biegewandlerelement, das einen mit einem piezoelektrischen Körper belegten Tragkörper aufweist, der als überwiegend mit unidirektionalen Carbon-Fasern verstärkter Kunstharzkörper ausgebildet ist.

Aus der DE 100 17 760 C1 oder der DE 20 2005 006 126 U ist ein Piezo-Biegewandler und ein damit ausgestattetes Piezoventil bekannt. Die bekannten Piezo-Biegewandler verfügen über einen aus mit Carbon-Fasern oder Glasfasern verstärktem Epoxidharz bestehenden Tragkörper, der einseitig mit einem piezoelektrischen Körper belegt ist. Zur Aktivierung wird an dem piezoelektrischen Körper eine Ansteuerspannung angelegt, was relativ zu dem Tragkörper eine Längenänderung hervorruft und zu einer seitlichen Auslenkung führt. Hierdurch kann beispielsweise die Fluidströmung in einem Ventil gesteuert werden. Damit sich das Biegewandlerelement unabhängig von Temperatureinflüssen neutral verhält, ist entweder der Tragkörper auf der dem piezoelektrischen Körper entgegengesetzten Seite mit einem als Anpassschicht bezeichneten Kompensationskörper belegt, der aus einem Material mit im Wesentlichen gleichem thermischen Ausdehnungskoeffizient wie der piezoelektrische Körper besteht oder der Tragkörper ist unmittelbar selbst als Kompensationskörper ausgebildet und weist im Wesentlichen das gleiche thermische Ausdehnungsverhalten wie der einseitig daran angebrachte piezoelektrische Körper auf.

Um die Auslenkung des Biegewandlerelements zu verbessern, wird in der DE 199 20 576 C1 vorgeschlagen, ein Fasermaterial mit einem sehr geringen Wärmeausdehnungskoeffizienten zu verwenden, nämlich Aramid-Fasern. Hierbei ergibt sich ein Elastizitätsmodul von 100 bis 130 GPa (entspricht 100 bis 130 x 10⁹ N/m²).

Eine Aufgabe der vorliegenden Erfindung besteht darin, die piezoelektrische Leistungsfähigkeit, insbesondere die Auslenkung noch weiter zu verbessern.

Diese Aufgabe wird erfindungsgemäß dadurch gelöst, dass der Tragkörper durch Verwendung von Hochmodul-Carbon-Fasern ein E-Modul von mehr als 180 GPa und einen thermischen Ausdehnungskoeffizienten von weniger als 2 x 10⁻⁶/K aufweist.

Die Vorteile des erfindungsgemäßen Biegewandlers bestehen insbesondere darin, dass das hohe E-Modul des Tragkörpers kombiniert mit einem niedrigen thermischen Ausdehnungskoeffizienten die angestrebte deutliche Steigerung der piezoelektrischen Leistungsfähigkeit erzielt. Insbesondere bei monomorphen Biegewandlern treten die Vorteile und die Verbesserung besonders deutlich hervor.

Durch die in den Unteransprüchen aufgeführten Maßnahmen sind vorteilhafte Weiterbildungen und Verbesserungen des im Anspruch 1 angegebenen Piezo-Biegewandlers möglich.

Noch bessere Ergebnisse erhält man mit einem Tragkörper, der ein E-Modul von mehr als 220 GPa und einen thermischen Ausdehnungskoeffizienten von weniger als 1 x 10⁻⁶/K, vorzugsweise weniger als 0,3 x 10⁻⁶/K aufweist.

Als besonders vorteilhaft hat es sich auch erwiesen, wenn der Tragkörper ein aus mindestens einem Prepreg hergestellter Duroplastkörper ist. Ein Prepreg ist, wie beispielsweise in der DE 199 20 576 C1 erläutert wird, ein noch nicht ausgehärteter, weicher, vorimprägnierte Fasern enthaltener Rohling, der bei der Herstellung des Biegewandlerelements mit dem piezoelektrischen Körper zusammengebracht wird, wonach die gesamte Einheit unter gleichzeitigem Verpressen einer erhöhten Temperatur ausgesetzt wird, so dass sich das in der Regel von Epoxidharz gebildete Grundmaterial bei seiner Aushärtung mit dem piezoelektrischen Körper haftend verbindet und eine stabile dauerhafte Baueinheit entsteht. Besonders vorteilhaft ist dabei die Verwendung von unidirektionalen Prepregs.

Als zweckmäßig hat sich auch die Ausbildung des piezoelektrischen Körpers als monomorphe piezoelektrische Lamelle erwiesen.

Die Dicke des Tragkörpers und/oder des piezoelektrischen Körpers beträgt vorzugsweise zwischen 80 und 400 µm.

Durch die Ausbildung eines solchen Piezo-Biegewandlers als Stellglied eines Piezo-Ventils können solche Piezo-Ventile mit hervorragender Schaltleistung gebildet werden.

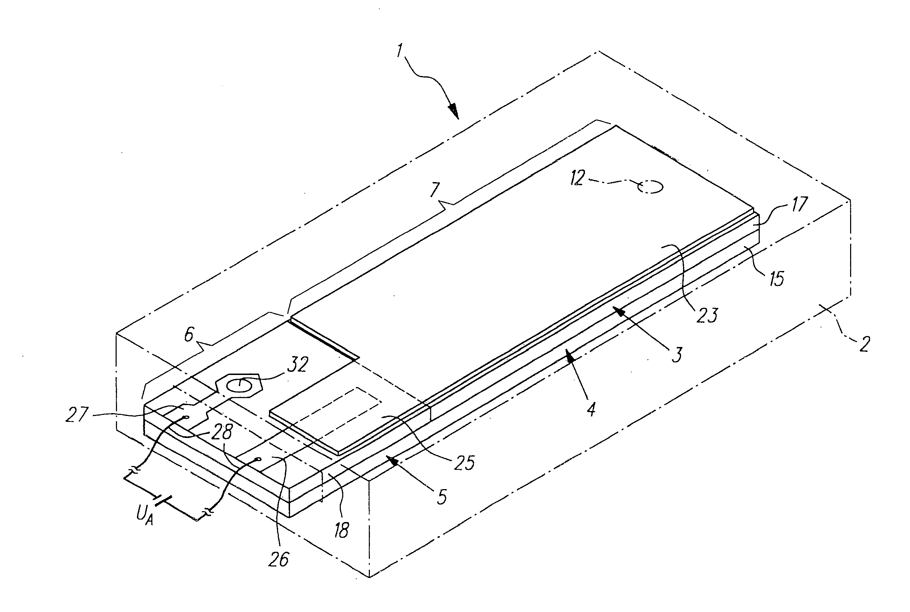

Ein Ausführungsbeispiel der Erfindung ist in der Zeichnung dargestellt und in der nachfolgenden Beschreibung näher erläutert. Die einzige Figur zeigt einen möglichen Aufbau eines Piezo-Biegewandlers in schematischer perspektivischer Darstellung als Ausführungsbeispiel der Erfindung in Zusammenhang mit einem Einsatz als Stellglied eine Piezoventils, wobei die weiteren Ventilkomponenten lediglich strichpunktiert angedeutet sind.

Die einzige Figur zeigt insgesamt in schematischer Weise ein zur Steuerung einer Fluidströmung dienendes Piezoventil 1. Dieses besitzt ein strichpunktiert angedeutetes Gehäuse 2, in dessen Innenraum ein als Stellglied fungierender Piezo-Biegewandler 3 angeordnet ist und insbesondere hineinragt.

Der Piezo-Biegewandler 3 enthält ein beim Ausführungsbeispiel streifenförmiges Biegewandlerelement 4, das an seinem rückwärtigen Endbereich 5 ventilgehäusefest fixiert ist. Es kann sich beispielsweise um eine Einspannung im ventilgehäuse handeln. In Abhängigkeit vom Anwendungsfall kann anstelle des ventilgehäuses auch eine andere Aufhängungsstruktur für die Halterung des Biegewandlerelementes 4 vorgesehen sein. Dies gilt insbesondere für membranartig gestaltete Piezo-Biegewandler, die an mehreren über ihren Umfang verteilten Stellen abgestützt bzw. fixiert sind.

Beim Ausführungsbeispiel bildet der rückwärtige Endbereich 5 des Biegewandlerelementes 4 einen Anschlussabschnitt 6, in dessen Bereich die für den Betrieb des Piezo-Biegewandlers 3 erforderliche elektrische Energie und elektrischen Signale zu- bzw. abgeführt werden. Dieser Anschlussabschnitt 6 ist zweckmäßigerweise stets piezoelektrisch inaktiv und enthält kein piezoelektrisches Material.

An den Anschlussabschnitt 6 schließt sich nach vorne hin ein als Arbeitsabschnitt 7 bezeichneter Längenabschnitt des Biegewandlerelementes 4 an, der aufgrund eines entsprechenden Aufbaus piezoelektrisch aktivierbar ist. Durch entsprechende elektrische Aktivierung kann erreicht werden, dass der Arbeitsabschnitt 7 in einer zu seiner Ausdehnungsebene rechtwinkeligen Auslenkebene seitwärts auslenkbar ist.

Das Biegewandlerelement 4 besitzt einen monomorphen Aufbau uns ist derart ausgelegt, dass es ausgehend von seiner aus der Zeichnung ersichtlichen, im deaktivierten Zustand eingenommenen Grundstellung durch Anlegen einer Aktivierungsspannung U_{A} in nur einer Richtung auslenkbar ist. Wird die Aktivierungsspannung U_{A} entfernt und das Biegewandlerelement 4 entladen, kehrt es in die Grundstellung zurück.

Durch die genannte Auslenkbewegung kann beispielsweise ein mit dem Biegewandlerelement 4 bewegungsgekoppeltes, in der Zeichnung nur strichpunktiert angedeutetes Ventilverschlussglied 12 relativ zu mindestens einer nicht näher dargestellten ventilgehäusefesten Ventilöffnung variabel positioniert werden, um den Fluiddurchfluss durch diese Ventilöffnung zu beeinflussen. In der maximalen Offenstellung ist das Ventilverschlussglied 12 weitest möglich von der Ventilöffnung entfernt, so dass innerhalb des Gehäuses eine Fluidströmung mit maximalem Durchfluss zwischen der Ventilöffnung und einer ebenfalls in den Innenraum des ventilgehäuses einmündenden weiteren Ventilöffnung möglich ist. In der Schließstellung wird die Ventilöffnung durch das Ventilverschlussglied 12 verschlossen und die Fluidströmung unterbunden. In Zwischenstellungen, die vom momentanen Grad der Auslenkung des Arbeitsabschnittes 7 abhängen, lässt sich bei variabler Aktivierungsspannung U_{A} eine variable Einstellung der Strömungsrate zwischen dem Maximalwert und dem Minimalwert vornehmen.

Das Piezoventil 1 kann so ausgelegt werden, dass es bei deaktiviertem, in der Grundstellung befindlichem Biegewandlerelement 4 entweder eine Schließstellung oder eine Offenstellung einnimmt.

Beim Ausführungsbeispiel sitzt das Ventilverschlussglied 12 direkt an dem als Stellglied fungierenden Biegewandlerelement 4. Man kann somit sagen, dass hier das Biegewandlerelement 4 unmittelbar ein Ventilglied bildet. Allerdings kann auch ein gesondertes Ventilglied vorhanden sein, das durch den als Stellglied fungierenden Piezo-Biegewandler 3 betätigbar ist.

Das Biegewandlerelement 4 besitzt einen streifenartigen Tragkörper 15, der aus einem piezoelektrisch nicht aktivierbarem Material besteht, nämlich aus mit unidirektionalen Hochmodul-Carbon-Fasern (HM-Fasern) verstärktem Kunststoffmaterial. Die Dicke liegt beispielsweise zwischen 80 und 400 µm. Durch die Verwendung von Hochmodul-Carbon-Fasern weist der Tragkörper 15 ein Elastizitätsmodul (E-Modul) von mehr als 180 GPa auf, wobei Werte über 220 GPa bevorzugt sind. Der thermische Ausdehnungskoeffizient des Tragkörpers 15 ist wesentlich geringer als der des piezoelektrischen Körpers 17, nämlich geringer als 2 x 10⁻⁶/K, wobei Werte kleiner als 1 x 10⁻⁶/K oder besser noch kleiner als 0,3 x 10⁻⁶/K eine bevorzugte Lösung darstellen. Hierdurch weist der Piezo-Biegewandler gemäß der vorliegenden Erfindung eine gegenüber bekannten Lösungen deutlich gesteigerte piezoelektrische Leistungsfähigkeit und eine höhere Auslenkungsfähigkeit auf.

Übliche hochfeste Carbon-Fasern (HT-Fasern) werden in einem zweistufigen Prozess hergestellt. Zunächst werden PAN-Fasern (Polyacrylnidril) bei 200 bis 300 Grad Celsius etwa eine Stunde behandelt. Ziel ist dabei eine Überführung in eine unschmelzbare Form unter Streckung und Cyclisierung der Fasern. Dann erfolgt in einem weiteren Prozessschritt (Carbonisierung) bei Temperaturen bis 1500 Grad Celsius unter Schutzgasatmosphäre die Umwandlung in Carbon-Fasern. Will man nun aus diesen Fasern Hochmodul-Carbon-Fasern (HM-Fasern) erhalten, so muss als dritte Stufe die sogenannte Graphitisierung durchlaufen werden. Hierbei werden die Fasern unter N₂ - oder Argon-Atmosphäre Temperaturen bis 3000 Grad Celsius ausgesetzt. Die so hergestellten HM-Fasern werden dann noch einer oxidativen Oberflächenbehandlung unterzogen, um eine bessere Adhäsion zwischen Faser und Polymer-Matrix zu erhalten.

An einer seiner beiden großflächigen Seiten, die im folgenden - ohne dass damit eine Einschränkung verbunden sein soll - als Oberseite bezeichnet wird, ist der Tragkörper 15 entlang seines Arbeitsabschnittes 7 mit einem bevorzugt ebenfalls streifenförmigen piezoelektrischen Körper 17 belegt, wobei im Fügebereich eine feste Verbindung vorliegt. Dessen Dicke kann beispielsweise ebenfalls im Bereich der Dicke des Tragkörpers 15 liegen.

Der piezoelektrische Körper 17 besitzt beim Ausführungsbeispiel einen monolithischen Aufbau und besteht aus einem piezoelektrisch aktivierbaren Material, beispielsweise einer Blei-Zirkonat-Titan-Oxidkeramik (PZT) oder einer anderen Piezokeramik.

Im Anschluss an den lediglich eine Teilfläche des Tragkörpers 15 überdeckenden piezoelektrischen Körper 17 ist der Tragkörper 15, im Bereich des Anschlussabschnittes 6, mit einem piezoelektrisch nicht aktivierbaren Kunststoffkörper 18 belegt, der zweckmäßigerweise die gleiche Breite und Dicke wie der piezoelektrische Körper 17 aufweist und bei dem es sich zweckmäßigerweise um einen Kunstharzkörper handelt. In dessen Bereich erfolgt die schon angesprochene Fixierung des Biegewandlerelementes 4 in seinem Gebrauchszustand.

Die der belegten Oberseite entgegengesetzte, als Unterseite bezeichnete zweite großflächige Seite des Tragkörpers 15 ist unbelegt. Man kann somit insgesamt von einem monomorphen Aufbau sprechen. Bei Bedarf können dort allerdings, wie auch an den anderen Außenflächen des Biegewandlerelementes, elektrische Schaltungskomponenten vorhanden sein. Auch kann das gesamte Biegewandlerelement 4 mit einem Überzug zum Schutz gegen Umwelteinflüsse, z.B. Feuchtigkeit, versehen sein.

Für die elektrische Aktivierung ist eine sich über die dem Tragkörper 15 entgegengesetzte Oberseite des piezoelektrischen Körpers 17 erstreckende obere Elektrodenschicht 23 vorgesehen. Diese könnte durch Einbrennsilber oder durch Besputteren realisiert sein. Besonders vorteilhaft ist allerdings die beim Ausführungsbeispiel vorgesehen Variante, bei der es sich um eine insbesondere durch Siebdruck aufgedruckte Elektrodenschicht handelt, vorzugsweise bestehend aus Carbon-Material, das zur Verarbeitung als Carbonlack vorliegt. Die Elektrodenschicht kann auch mittels eines Sprühverfahrens aufgebracht sein.

Die obere Elektrodenschicht 23 ragt beim Ausführungsbeispiel rückseitig über den piezoelektrischen Körper 17 hinaus und bedeckt auch eine Teilfläche der Oberseite des im Anschlussabschnitt 6 vorgesehenen Kunststoffkörpers 18. Dieser Bestandteil der Elektrodenschicht 23 sei als Kontaktierungsabschnitt 25 bezeichnet.

Der Tragkörper 15 ist bei dem Ausführungsbeispiel aufgrund der mit Carbon-Material ausgeführten Faserverstärkung elektrisch leitfähig. Dadurch bildet der Tragkörper 15 eine den piezoelektrischen Körper 17 auf der entgegengesetzten Seite wie die obere Elektrodenschicht 23 flankierende untere Elektrodenschicht. Zur Aktivierung des Biegewandlerelementes 4 wird an die beiden Elektrodenschichten die erwähnte Aktivierungsspannung U_{A} angelegt, mit der Folge, dass sich der piezoelektrische Körper 17 aufgrund des umgekehrten piezoelektrischen Effektes verkürzt und das Biegewandlerelement 4 aufgrund des die Verkürzung nicht mitmachenden Tragkörpers 15 gekrümmt bzw. ausgelenkt wird.

Zur Kontaktierung der beiden Elektrodenschichten weist das Biegewandlerelement 4 an der dem Tragkörper 15 entgegengesetzten Oberseite des Kunststoffkörpers 18 zwei von elektrisch leitenden Flächen gebildete Anschlusspads 26, 27 auf. Diese sind von wegführenden elektrischen Leitern 28 kontaktiert, die beispielsweise durch Anlöten oder Ankleben elektrisch leitend angeschlossen sind. Es kann sich um einzelne elektrische Leiter handeln oder beispielsweise um elektrische Leiter einer flexiblen Leiterplatte bzw. Flexschaltung.

Eines der Anschlusspads 26 erstreckt sich unter den Kontaktierungsabschnitt 25 der oberen Elektrodenschicht 23 und steht mit diesem in elektrisch leitender Verbindung. Die Verbindung kommt automatisch beim Auftragen der oberen Elektrodenschicht 23 zustande.

Das andere Anschlusspad 27 ist über eine den Kunststoffkörper 18 durchsetzende Durchkontaktierung mit dem darunter liegenden, gleichzeitig eine Elektrodenfunktion übernehmenden Tragkörper 15 elektrisch leitend verbunden. Um eine sichere elektrische Verbindung zu erhalten, ist der Tragkörper 15 an seiner Oberseite 16 im Bereich der Durchkontaktierung zweckmäßigerweise noch mit einer bevorzugt padartigen Metallisierung versehen, beispielsweise einer Kupferschicht, die in der zeichnerischen Darstellung nicht erkennbar ist.

An dieser Stelle sei erwähnt, dass der piezoelektrische Körper 17 auch einen Multilayeraufbau besitzen kann. Er enthält dann mehrere von Elektrodenschichten flankierte piezoelektrische Materialschichten, die in geeigneter Weise mit den Anschlusspads 26, 27 kontaktiert sind, wobei aber auch hier der Tragkörper 15 bei Bedarf die Funktion der untersten Elektrodenschicht übernehmen kann.

Der Piezo-Biegewandler kann auch noch in an sich bekannter Weise einen Kompensationskörper aufweisen, der an der dem piezoelektrischen Körper 17 gegenüberliegenden Seite des Tragkörpers 15 angeordnet wird, selbst nicht piezoelektrisch wirksam ist, jedoch dasselbe thermische Ausdehnungsverhalten wie der piezoelektrische Körper besitzt. Man verhindert dadurch innere Spannungen, die sich dem ausschließlich gewünschten piezoelektrischen Effekt überlagern und das Betriebsverhalten des Biegewandlerelements 4 beeinträchtigen.

Trotz der elektrischen Leitfähigkeit des Trägkörpers 15 kann zwischen diesem und dem piezoelektrischen Körper 17 zusätzlich eine Elektrodenschicht vorgesehen sein, deren Aufbau zweckmäßigerweise demjenigen der gesonderten oberen Elektrodenschicht 23 entspricht.

Der Tragkörper 15 ist ein aus mindestens einem Prepreg hergestellter HM-faserverstärkter Duroplastkörper. Der Prepreg ist ein bevorzugt plattenartiger, noch nicht ausgehärteter biegeschlaffer Rohling mit eingebetteten Fasern, der über klebrige Eigenschaften verfügt, und auf den der piezoelektrische Körper aufgelegt wird, so dass sich zunächst eine Haftverbindung einstellt. Bei gleichzeitigem leichtem Zusammenpressen wird dieser Körperverbund einer Wärmebehandlung ausgesetzt, wobei das Prepreg irreversibel unter Bildung eines Duroplasten aushärtet und eine innige Verbindung mit dem piezoelektrischen Körper 17 eingeht. Eine solche Art der Herstellung geht grundsätzlich aus der DE 199 20 576 C1 hervor und erweist sich als vorteilhaft auch zur Realisierung des erfindungsgemäßen Piezo-Biegewandlers.

Der Rückgriff auf die sogenannten Prepregs eröffnet auch die Möglichkeit, den Tragkörper 15 nicht nur aus einem einzigen, sondern aus mehreren geschichtet aneinandergesetzten Prepregs herzustellen, wie dies z.B. in der DE 20 2005 006 126 U beschrieben ist. Bei den Carbon-Fasern im Tragkörper 15 handelt es sich bevorzugt ausschließlich um HM-Carbon-Fasern, es ist jedoch für bestimmte Anwendungen auch möglich, kleinere Anteile von anderen Fasern mit zu verwenden. Bei mehreren Prepreg-Schichten können die einzelnen Schichten mit unterschiedlichen Faseranordnungen oder Beimengungen versehen sein.

## Patentansprüche

1. Piezo-Biegewandler mit einem streifen- oder plattenförmigen Biegewandlerelement (4), das einen mit einem piezoelektrischen Körper (17) belegten Tragkörper (15) aufweist, der als überwiegend mit unidirektionalen Carbon-Fasern verstärkter Kunstharzkörper ausgebildet ist, **dadurch gekennzeichnet, dass** der Tragkörper (15) durch Verwendung von Hochmodul-Carbon-Fasern ein E-Modul größer als 180 GPa und einen thermischen Ausdehnungskoeffizienten kleiner als 2 x 10⁻⁶/K aufweist.

2. Piezo-Biegewandler nach Anspruch 1, **dadurch gekennzeichnet, dass** der Tragkörper (15) ein E-Modul größer als 220 GPa aus einen thermischen Ausdehnungskoeffizienten kleiner als 1 x 10⁻⁶/K aufweist.

3. Piezo-Biegewandler nach Anspruch 2, **dadurch gekennzeichnet, dass** der Tragkörper (15) einen thermischen Ausdehnungskoeffizienten kleiner als 0,3 x 10⁻⁶/K aufweist.

4. Piezo-Biegewandler nach einem der vorhergehenden Ansprüche, **dadurch gekennzeichnet, dass** der Tragkörper (15) ein aus mindestens einem Prepreg hergestellter Duroplastkörper ist.

5. Piezo-Biegewandler nach Anspruch 4, **dadurch gekennzeichnet**, der mindestens eine Prepreg als unidirektionaler Prepreg ausgebildet ist.

6. Piezo-Biegewandler nach einem der vorhergehenden Ansprüche, **dadurch gekennzeichnet, dass** der piezoelektrische Körper (17) als monomorphe piezoelektrische Lamelle ausgebildet ist.

7. Piezo-Biegewandler nach einem der vorhergehenden Ansprüche, **dadurch gekennzeichnet, dass** die Dicke des Tragkörpers (15) und/oder des piezoelektrischen Körpers (17) zwischen 80 und 400 µn beträgt.

8. Piezo-Biegewandler nach einem der vorhergehenden Ansprüche, **dadurch gekennzeichnet, dass** er als Stellglied eines Piezo-Ventils (1) ausgebildet ist.
